# EUROPÄISCHE PATENTSCHRIFT

(11) **EP 2 834 851 B1**
(45) Veröffentlichungstag und Bekanntmachung des Hinweises auf die Patenterteilung: **12.08.2020**
(21) Anmeldenummer: 13704463.2
(22) Anmeldetag: 18.02.2013
(51) Int. Cl.: H01L 31/0224, H01L 31/032, H01L 31/0749

(54) **VERFAHREN ZUR HERSTELLUNG EINER MEHRSCHICHT-RÜCKELEKTRODE FÜR EINE PHOTOVOLTAISCHE DÜNNSCHICHTSOLARZELLE, MEHRSCHICHT-RÜCKELEKTRODE ERHALTEN NACH DEM VERFAHREN, PHOTOVOLTAISCHE DÜNNSCHICHTSOLARZELLEN UND -MODULE ENTHALTEND DIE MEHRSCHICHT-RÜCKELEKTRODE**
METHOD FOR THE PRODUCTION OF A MULTI-LAYER BACK ELECTRODE FOR A PHOTOVOLTAIC THIN-FILM SOLAR CELL, MULTI-LAYER BACK ELECTRODE ACCORDING TO THE METHOD, PHOTOVOLTAIC THIN-FILM SOLAR CELL AND MODULE COMPRISING THE MULTI-LAYER BACK ELECTRODE
PROCÉDÉ DE FABRICATION D'UN ÉLECTRODE ARRIÈRE MULTICOUCHE POUR UNE CELLULE PHOTOVOLTAÏQUE EN COUCHES MINCES, ÉLECTRODE ARRIÈRE MULTICOUCHES SELON LE PROCÉDÉ, CELLULE ET MODULE PHOTOVOLTAÏQUE EN COUCHES MINCES COMPRENANT CET ÉLECTRODE ARRIÈRE MULTICOUCHE

(30) Priorität: 02.04.2012 DE 102012205377
(43) Veröffentlichungstag der Anmeldung: 11.02.2015
(73) Patentinhaber: NICE Solar Energy GmbH, 74523 Schwäbisch Hall (DE)
(72) Erfinder: Probst, Volker, 14089 Berlin (DE)
(74) Vertreter: Metten, Karl-Heinz
(86) Internationale Anmeldenummer: PCT/EP2013/053144
(87) Internationale Veröffentlichungsnummer: WO 2013/149756

(56) Entgegenhaltungen:
- EP-A1- 1 833 096
- WO-A1-2011/155639
- AT-U1- 10 578
- JP-A- 2011 198 883
- US-A1- 2005 074 915
- ORGASSA K ET AL: "Alternative back contact materials for thin film Cu(In,Ga)Se2 solar cells", THIN SOLID FILMS, ELSEVIER-SEQUOIA S.A. LAUSANNE, CH, Bd. 431-432, 1. Mai 2003 (2003-05-01), Seiten 387-391, XP004428673, ISSN: 0040-6090, DOI: 10.1016/S0040-6090(03)00257-8 in der Anmeldung erwähnt
- T. WADA ET AL.: "Chemical and Structural Characterization of Cu(In,Ga)Se2/Mo Interface in Cu(In,Ga)Se2 Solar Cells", JPN. J. APPL. PHYS., Bd. 35, Nr. 10A, 1996, Seiten 1253-1256, XP002696719,
- PATRICK BLÃSCH ET AL: "Comparative Study of Different Back-Contact Designs for High-Efficiency CIGS Solar Cells on Stainless Steel Foils", IEEE JOURNAL OF PHOTOVOLTAICS, I E E E, US, Bd. 1, Nr. 2, 1. Oktober 2011 (2011-10-01) , Seiten 194-199, XP011390833, ISSN: 2156-3381, DOI: 10.1109/JPHOTOV.2011.2166589 in der Anmeldung erwähnt

## Beschreibung

Die folgende Erfindung betrifft ein Verfahren zur Herstellung einer Mehrschicht-Rückelektrode für eine photovoltaische Dünnschichtsolarzelle, eine Mehrschicht-Rückelektrode erhalten nach dem Verfahren, photovoltaische Dünnschichtsolarzellen enthaltend die erfindungsgemäße Mehrschicht-Rückelektrode, die Verwendung der Mehrschicht-Rückelektrode für die Herstellung von Dünnschichtsolarzellen und Dünnschichtsolarmodulen sowie die Dotierung einer Halbleiterabsorberschicht und die Verwendung der Dünnschichtsolarzelle für die Herstellung von Dünnschichtsolarmodulen.

Geeignete Photovoltaik-Solarmodule umfassen einerseits kristalline und amorphe Siliziumsolarmodule und andererseits sogenannte Dünnschichtsolarmodule. Bei letzteren kommt im Allgemeinen eine IB-IIIA-VIA-Verbindungshalbleiterschicht, eine sogenannte Chalkopyrit-Halbleiterabsorberschicht zum Einsatz. Bei diesen Dünnschichtsolarmodulen liegt auf einem Glassubstrat üblicherweise eine Molybdänrückelektrodenschicht auf. Diese wird in einer Verfahrensvariante mit einer Kupfer und Indium sowie gegebenenfalls Gallium umfassenden Precursor-Metalldünnschicht versehen und anschließend in Gegenwart von Schwefelwasserstoff und/oder Selenwasserstoff und/oder Selen oder Schwefel bei erhöhten Temperaturen zu einem sogenannten CIS- bzw. CIGS-System umgesetzt.

Um einen akzeptablen Wirkungsgrad zuverlässig erreichen zu können, ist in der Regel schon bei der Wahl und Herstellung der Rückelektrodenschicht besondere Obacht erforderlich.

Beispielsweise hat die Rückelektrodenschicht über eine hohe Querleitfähigkeit zu verfügen, um eine verlustarme Serienverschaltung sicherzustellen. Auch sollten aus dem Substrat und/oder der Halbleiterabsorberschicht migrierende z.B. diffundierende Substanzen keinen Einfluss auf die Qualität und Funktionsweite der Rückelektrodenschicht haben. Darüber hinaus muss das Material der Rückelektrodenschicht eine gute Anpassung an das thermische Ausdehnungsverhalten von Substrat und den darüber liegenden Schichten aufweisen, um Mikrorisse zu vermeiden. Schließlich sollte auch die Haftung auf der Substratoberfläche allen gängigen Nutzungsanforderungen genügen.

Zwar ist es möglich, zu guten Wirkungsgraden über den Einsatz von besonders reinem Rückelektrodenmaterial zu gelangen, allerdings gehen hiermit regelmäßig unverhältnismäßig hohe Produktionskosten einher. Zudem führen die vorangehend genannten Migrationsphänomene insbesondere Diffusionsphänomene unter den üblichen Produktionsbedingungen nicht selten zu einer signifikanten Verunreinigung des Rückelektrodenmaterials.

JP 2011/198883 offenbart eine Molbydän-Elektrode, welche mit Schwefel oder Selen in der Gasphase bei 0 bis 0,05 mPa und 300 bis 600°C behandelt wird. Es findet eine chemische Reaktion der Molbydän-Elektrode mit Gasen der Gasphase statt, wobei eine Schicht enthaltend MoSe₂ bzw. MoS₂ ausgebildet wird.

Zu einer Solarzelle mit morphologisch gut ausgebildeter Absorberschicht und guten Wirkungsgraden soll man gemäß der DE 44 42 824 C1 dadurch gelangen, dass man die Chalkopyrit-Halbleiterabsorberschicht mit einem Element aus der Gruppe Natrium, Kalium und Lithium in einer Dosis von 10¹⁴ bis 10¹⁶ Atomen/cm² dotiert und gleichzeitig eine Diffusionssperrschicht zwischen dem Substrat und der Halbleiterabsorberschicht vorsieht. Alternativ wird vorgeschlagen, ein alkalifreies Substrat zu verwenden, sofern auf eine Diffusionssperrschicht verzichtet werden soll.

Blösch et al. (Thin Solid Films 2011) schlagen vor, bei Verwendung einer Polyimidsubstratfolie ein Schichtsystem aus Titan, Titannitrid und Molybdän zu verwenden, um gute Haftungseigenschaften und ein zufriedenstellendes thermisches Eigenschaftsprofil zu erhalten. Blösch et al. (IEEE, 2011, Vol. 1, Nr. 2, Seiten 194 bis 199) schlagen für die Verwendung flexibler Dünnschichtsolarzellen ferner den Einsatz einer Edelstahlsubstratfolie vor, auf welche zunächst zwecks Verbesserung der Haftung eine dünne Titanschicht aufgebracht wird. Zufriedenstellende Ergebnisse wurden mit solchen CIGS-Dünnschichtsolarzellen erzielt, welche mit einer Titan/Molybdän/Molybdän-Dreifachlage ausgestattet waren. Verbesserte Dünnschichtsolarzellen werden auch mit der technischen Lehre der WO 2011/123869 A2 angestrebt. Die darin offenbarte Solarzelle umfasst ein Natriumglassubstrat, eine Molybdän-Rückelektrodenschicht, eine CIGS-Schicht, eine Pufferschicht, eine Schicht aus intrinsischem Zinkoxid und eine Schicht aus mit Aluminium dotiertem Zinkoxid. Ein erster Trenngraben erstreckt sich über die Molybdänschicht, die CIGS-Schicht und die Pulverschicht, ein zweiter Trenngraben beginnt oberhalb der Molybdänschicht. Ein isolierendes Material wird in bzw. auf dem ersten Trenngraben abgeschieden, und eine Frontelektrodenschicht ist schräg auf die Solarzelle, einschließlich des ersten Trenngrabens, abzuscheiden. Auf diese Weise sollen Dünnschichtsolarzellen mit verbesserter Lichtausbeute erhalten werden. Die US 2004/0144419 A1 ist bestrebt, eine Dünnschichtsolarzelle zur Verfügung zu stellen, deren Molybdän-Rückelektrodenschicht über einen verbesserten Wirkungsgrad verfügt. Dieses soll dadurch erreicht werden, dass man ein Glassubstrat mit einer Rückelektrodenschicht aus Molybdän versieht, deren Dicke 500 nm nicht überschreiten soll.

Dass unterschiedlichste Metalle wie Wolfram, Molybdän, Chrom, Tantal, Niob, Vanadium, Titan und Mangan als geeignete Rückelektrodenmaterialen für Dünnschichtsolarzellen in Frage kommen, ist schon bei Orgassa et al. (Thin Solid Films, 2003, Vol. 431-432, Seiten 387 bis 391) zu finden.

Daher lag der vorliegenden Erfindung die Aufgabe zugrunde, Rückelektrodensysteme für Dünnschichtsolarzellen bzw. -module zur Verfügung zu stellen, die nicht mehr mit den Nachteilen des Stands der Technik behaftet sind und die insbesondere auf kostengünstige und zuverlässige Weise reproduzierbar zu Dünnschichtsolarmodulen mit hohen Wirkungsgraden führen.

Demgemäß wurde ein Verfahren zur Herstellung einer Mehrschicht-Rückelektrode für eine photovoltaische Dünnschichtsolarzelle gefunden, wobei die Mehrschicht-Rückelektrode umfasst, in dieser Reihenfolge,
mindestens eine Bulk-Rückelektrodenschicht,
mindestens eine, insbesondere Ohm'sche, Kontaktschicht, wobei
die Kontaktschicht erhalten wird durch:
- Auftragen mindestens einer Lage enthaltend oder im Wesentlichen aus mindestens einem Metallchalkogenid mittels physikalischer oder chemischer Gasphasenabscheidung unter Verwendung mindestens einer Metallchalkogenidquelle, wobei das Metall des Metallchalkogenids ausgewählt ist aus Molybdän, Wolfram, Tantal, Cobalt, Zirconium und/oder Niob, insbesondere wobei das Chalkogen des Metallchalkogenids ausgewählt ist aus Selen und/oder Schwefel oder
- Auftragen mindestens einer Metalllage als erste Lage, wobei die erste Lage und die Bulk-Rückelektrodenschicht in dem jeweils verwendetem Metall oder, sofern mehrere Metalle in der Metalllage und der Bulk- Rückelektrodenschicht vorliegen, hinsichtlich mindestens eines, insbesondere sämtlicher dieser Metalle, nicht übereinstimmen, enthaltend oder im Wesentlichen aus Mo, W, Ta, Zr, Nb und/oder Co mittels physikalischer Gasphasenabscheidung unter Verwendung mindestens einer Metallquelle und Behandeln dieser Metalllage bei Temperaturen oberhalb von 300°C in einer Chalkogenatmosphäre und/oder Chalkogenwasserstoffatmosphäre, insbesondere Selen- und/oder Schwefelatmosphäre und/oder H₂S- und/oder H₂Se-Atmosphäre, unter Ausbildung einer Metallchalkogenidlage als zweite Lage.

Dabei sind für die Kontaktschicht des erfindungsgemäßen Verfahrens, insbesondere solche Ausführungsformen geeignet, bei denen das Metallchalkogenid MSe₂, MS₂ und/oder M(Se₁₋ₓ,Sₓ) darstellt mit M = Mo, W, Ta, Zr, Co oder Niob und insbesondere ausgewählt ist aus der Gruppe bestehend aus MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ und/oder Nb(Se₁₋ₓ,Sₓ)₂, wobei x beliebige Werte von 0 bis 1 annimmt.

In einer Weiterentwicklung ist ferner vorgesehen, dass mindestens eine leitfähige Barriereschicht, insbesondere bidirektionale Barriereschicht, zwischen der Bulk-Rückelektrodenschicht und der Kontaktschicht vorliegt.

Die Barriereschicht stellt hierbei bevorzugt eine Barriere für aus der und/oder über die Bulk-Rückelektrodenschicht migrierende, insbesondere diffundierende bzw. diffundierbare Komponenten und/oder für aus der und/oder über die Kontaktschicht diffundierende bzw. diffundierbare Komponenten dar. Besonders geeignet sind auch solche Rückelektroden, bei denen die Barriereschicht eine Barriere für Alkaliionen, insbesondere Natriumionen, Selen oder Selenverbindungen, Schwefel oder Schwefelverbindungen, Metalle, insbesondere Cu, In, Ga, Fe, Ni, Ti, Zr, Hf, V, Nb, Al, Ta und/oder W, und/oder Verbindungen enthaltend Alkaliionen darstellt. Hierbei ist insbesondere vorgesehen, dass die Barriereschicht enthält oder im Wesentlichen gebildet ist aus mindestens einem Metallnitrid, insbesondere TiN, MoN, TaN, ZrN und/oder WN, mindestens einem Metallcarbid, mindestens einem Metallborid und/oder mindestens einem Metallsiliziumnitrid, insbesondere TiSiN, TaSiN und/oder WSiN. Das Metall der Metallnitride, Metallsitiziumnitride, Metallcarbide und/oder Metallboride stellt in einer geeigneten Ausgestaltung Titan, Molybdän, Tantal, Zirkonium oder Wolfram dar. Derartige Metallnitride sind bevorzugt als Barrierematerialien im Sinne der vorliegenden Erfindung, beispielsweise TiN, bei denen das Metall hinsichtlich Stickstoff stöchiometrisch oder überstöchiometrisch, also mit Stickstoff im Überschuss, abgeschieden wird.

Die leitfähige Barriereschicht stellt als bidirektional wirkende Barriereschicht eine Barriere für aus der und/oder über die Rückelektrodenschicht migrierende, insbesondere diffundierende bzw. diffundierbare Komponente, insbesondere Dotierstoffe, und für aus der und/oder über die Kontaktschicht, insbesondere aus der Halbleiterabsorberschicht, diffundierende bzw. diffundierbare Komponente, insbesondere Dotierstoffe, dar. Bedingt durch den Umstand des Vorliegens einer Barriereschicht ist es z.B. möglich, den Reinheitsgrad des Bulk- Rückelektrodenmaterials signifikant zu reduzieren. Beispielsweise kann die Bulk- Rückelektrodenschicht verunreinigt sein mit mindestens einem Element ausgewählt aus der Gruppe bestehend aus Fe, Ni, Al, Ti, Zr, Hf, V, Nb, Ta, W und/oder Na und/oder mit Verbindungen der genannten Elemente, ohne dass der Wirkungsgrad der die erfindungsgemäße Rückelektrode aufweisenden Dünnschichtsolarzelle bzw. des -moduls nachhaltig beeinträchtigt wird.

Ein weiterer Vorteil des Einsatzes einer Barriereschicht mit der erfindungsgemäß hergestellten Mehrschicht-Rückelektroden manifestiert sich bei Verwendung in Dünnschichtsolarzellen und - modulen darin, dass die Dicke der Halbleiterabsorberschicht, beispielsweise der Chalkopyrit- oder Kesterit- Schicht, gegenüber herkömmlichen System merklich verringert werden kann. Denn durch die Barriereschicht, insbesondere wenn in Form von Metallnitriden, beispielsweise Titannitrid, oder enthaltend solche Metall- bzw. Titannitride vorliegend, wird das die Halbleiterabsorberschicht passierende Sonnenlicht sehr effektiv reflektiert, so dass sich im Wege des Doppeldurchtritts durch die Halbleiterabsorberschicht eine sehr gute Quantenausbeute erzielen lasst. Durch die Anwesenheit der genannten Barriereschicht in der erfindungsgemäßen Rückelektrode bzw. in Dünnschichtsolarzellen bzw. -modulen, enthaltend diese Rückelektrode kann die durchschnittliche Dicke der Halbleiterabsorberschicht auf z. B. Werte im Bereich von 0,4 pm bis 1,5 µm, beispielsweise auf werte im Bereich von 0,5 µm bis 1,2 µm, verringert werden..

Die Barriereschicht der erfindungsgemäßen Rückelektrode verfügt in einer besonders zweckmäßigen Ausgestaltung über Barriereeigenschaften, insbesondere bidirektionale Barriereeigenschaften, gegenüber Dotierstoffen, insbesondere gegenüber Dotierstoffen für die Halbleiterabsorberschicht und/oder aus der Halbleiterabsorberschicht, gegenüber Chalkogenen wie Selen und/oder Schwefel sowie Chalkogenverbindungen, gegenüber den metallischen Bestandteilen der Halbleiterabsorberschicht wie Cu, In, Ga, Sn und/oder Zn, und gegenüber Verunreinigungen wie Eisen und/oder Nickel aus der Bulk-Rückelektrodenschicht und/oder gegenüber Komponenten und/oder Verunreinigungen aus dem Substrat. Die bidirektionalen Barriereeigenschaften gegenüber Dotierstoffen aus dem Substrat sollen zum einen eine Anreicherung an der Grenzfläche der Rückelektrode bzw. Kontaktschicht zur Halbleiterabsorberschicht mit Alkaliionen, z.B. ausdiffundierend aus einem Glassubstrat, verhindern. Solche Anreicherungen sind bekannt als Grund für Halbleiter-Schichtablösungen. Die leitfähige Barrierenschicht soll damit Haftungsprobleme vermeiden helfen. Andererseits soll die Barriereeigenschaft für Dotierstoffe, ausdiffundierbar bzw. ausdiffundierend aus dem Halbleiterabsorber, verhindern, dass Dotierstoff auf diese Weise an die Bulk-Rückelektrode verlorengeht und damit der Halbleiterabsorber an Dotierstoff verarmt, was den Wirkungsgrad der Solarzelle oder des Solarmoduls deutlich reduzieren würde. Denn es ist beispielsweise bekannt, dass Molybdän-Rückelektroden signifikante Mengen an Natrium-Dotierstoff aufnehmen können. Die bidirektionale leitfähige Barriereschicht soll somit die Voraussetzungen für eine gezielte Dosierung von Dotierstoff in die Halbleiterabsorberschicht ermöglichen, um reproduzierbar hohe Wirkungsgrade der Solarzellen und -Modulen erreichen zu können.

Die Barriereeigenschaft gegenüber Chalkogenen soll verhindern, dass diese an die Rückelektrode gelangen und dort Metallchalkogenidverbindungen ausbilden. Bekanntlich tragen diese Chalkogenidverbindungen, z.B. MoSe, zu einer erheblichen Volumenvergrößerung der oberflächennahen Schicht der Rückelektrode bei, was wiederum Unebenheiten in der Schichtenstruktur und verschlechterte Haftung mit sich bringt. Verunreinigungen des Bulk-Rückelektrodenmaterials wie Fe und Ni stellen sogenannte tiefe Störstellen für Chalkopyrit-Halbleiter (Halbleitergifte) dar und sind demzufolge über die Barriereschicht von der Halbleiterabsorberschicht fernzuhalten.

Geeignete erfindungsgemäße Mehrschicht-Rückelektroden zeichnen sich auch dadurch aus, dass die Bulk-Rückelektrodenschicht enthält oder im Wesentlichen gebildet ist aus V, Mn, Cr, Mo, Ti, Co, Zr, Ta, Nb und/oder W und/oder enthält oder im Wesentlichen gebildet ist aus einer Legierung enthaltend V, Mn, Cr, Mo, Ti, Co, Fe, Ni, Al, Zr, Ta, Nb und/oder W.

Hierbei kann insbesondere vorgesehen sein, dass die Bulk-Rückelektrodenschicht verunreinigt ist mit mindestens einem Element ausgewählt aus der Gruppe bestehend aus Fe, Ni, Al, Ti, Zr, Hf, V, Nb, Ta, W und/oder Na und/oder mit Verbindungen der genannten Elemente.

Es hat sich als besonders geeignet erwiesen, wenn das Metall der ersten Lage und das Metall der zweiten Lage der Kontaktschicht übereinstimmen und/oder dass das Metall der ersten Lage und/oder das Metall der zweiten Lage der Kontaktschicht mit dem Metall der Bulk- Rückelektrodenschicht übereinstimmen.

Von besonderem praktischem Nutzen sind auch solche erfindungsgemäßen Rückelektroden, bei denen die Kontaktschicht, die erste und/oder die zweite Lage der Kontaktschicht mindestens einen Dotierstoff für eine Halbleiterabsorberschicht einer Dünnschichtsolarzelle, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist. Geeignete Bronzen umfassen beispielsweise Mischoxide oder Mischungen aus Mischoxiden und Oxiden, beispielsweise Na₂MoO₂ + WO. Die dotierte Kontaktschicht ist zum Beispiel erhältlich durch Auftragen des mit dem Dotierstoff in der Metallchalkogenidquelle versetzten Metallchalkogenid.

Für den Fall der Dotierung der Kontaktschicht mit Dotierstoffen für die Halbleiterabsorberschicht einer Dünnschichtsolarzelle hat sich die erfindungsgemäße Mehrschicht-Rückelektrode bewahrt. Bei der Herstellung der Halbleiterabsorberschicht werden regelmäßig Temperaturen oberhalb von 300 bzw. oberhalb von 350°C eingesetzt. Häufig liegen diese Temperaturen auch im Bereich von 500°C bis 600°C. Bei derartigen Temperaturen migrieren, insbesondere diffundieren, Dotierstoffe, wie insbesondere Natriumionen bzw. Natriumverbindungen, aus der dotierten Kontaktschicht in die Halbleiterabsorberschicht. Bedingt durch die Barriereschicht findet eine Migration bzw. Diffusion in die Rückelektrodenschicht nicht statt.

Aufgrund der genannten relativ hohen Temperaturen bei der Prozessierung des Halbleiters ist es vorteilhaft, dass die ausgewählten Schichten der erfindungsgemäß hergestellten Mehrschichtrückelektrode, insbesondere die Bulk-Rückelektrode und/oder die leitfähige Barrierenschicht so zusammengesetzt sind, dass deren linearer thermischer Ausdehnungskoeffizient an den des Halbleiterabsorbers und/oder des Substrates angepasst sind. Daher sollten insbesondere die Bulk-Rückelektrode und/oder die Barriereschicht der erfindungsgemäßen Dünnschichtsolarzellen und - module vorzugsweise so zusammengesetzt sein, dass ein linearer thermischer Ausdehnungskoeffizient von 14*10⁻⁶⁻K, bevorzuget von 9*10⁻⁶⁻K nicht überschritten wird.

Im Sinne der vorliegenden Erfindung sollen die physikalische Gasphasenabscheidung Physical Vapor Deposition (PVD)-Beschichtung, Aufdampfen mittels eines Elektronenstrahl- Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, und die chemische Gasphasenabscheidung Chemical Vapour Deposition (CVD), Niedrigdruck- (low pressure) CVD und/oder Atmosphären- (atmospheric pressure) CVD umfassen.

Die Aufgabe der vorliegenden Erfindung wird ferner gelöst durch eine Mehrschicht-Rückelektrode hergestellt nach dem erfindungsgemäßen Verfahren , wobei die Mehrschicht-Rückelektrode umfasst, in dieser Reihenfolge,
mindestens eine Bulk-Rückelektrodenschicht,
mindestens eine, insbesondere Ohm'sche, Kontaktschicht, dadurch gekennzeichnet, dass die Kontaktschicht erhalten wird durch:
- Auftragen mindestens einer Lage enthaltend oder im Wesentlichen aus mindestens einem Metallchalkogenid mittels physikalischer oder chemischer Gasphasenabscheidung unter Verwendung mindestens einer Metallchalkogenidquelle, wobei das Metall des Metallchalkogenids ausgewählt ist aus Molybdän, Wolfram, Tantal, Cobalt, Zirconium und/oder Niob, insbesondere wobei das Chalkogen des Metallchalkogenids ausgewählt ist aus Selen und/oder Schwefel oder
- Auftragen mindestens einer Metalllage als erste Lage, wobei die erste Lage und die Bulk-Rückelektrodenschicht in dem jeweils verwendetem Metall oder, sofern mehrere Metalle in der Metalllage und der Bulk- Rückelektrodenschicht vorliegen, hinsichtlich mindestens eines, insbesondere sämtlicher dieser Metalle, nicht übereinstimmen, enthaltend oder im Wesentlichen aus Mo, W, Ta, Zr, Nb und/oder Co mittels physikalischer Gasphasenabscheidung unter Verwendung mindestens einer Metallquelle und Behandeln dieser Metalllage bei Temperaturen oberhalb von 300°C in einer Chalkogenatmosphäre und/oder Chalkogenwasserstoffatmosphäre, insbesondere Seten- und/oder Schwefelatmosphäre und/oder H₂S- und/oder H₂Se-Atmosphäre, unter Ausbildung einer Metallchalkogenidlage als zweite Lage.

Eine besonders geeignete Ausführungsform der erfindungsgemäßen Rückelektrode sieht ferner vor, dass die durchschnittliche Dicke der Bulk-Rückelektrodenschicht im Bereich von 50 nm bis 500 nm, insbesondere im Bereich von 80 nm bis 250 nm, und/oder der Barriereschicht im Bereich von 10 nm bis 250 nm, insbesondere im Bereich von 20 nm bis 150 nm, und/oder der Kontaktschicht im Bereich von 2 nm bis 200 nm, insbesondere im Bereich von 5 nm bis 100 nm, liegt. Dabei ist die Gesamtdicke der Mehrschicht- Rückelektrode vorzugsweise so einzustellen, dass der spezifische Gesamtwiderstand der erfindungsgemäßen Ruckelektrode 50 microOhm*cm, bevorzugt 10 microOhm*cm, nicht überschreitet. Unter diesen Vorgaben lassen sich Ohm'sche Verluste in einem serienverschalteten Modul nochmals zu reduzieren.

Besonders bevorzugt sind auch solche erfindungsgemäßen Mehrschicht-Rückelektroden, bei denen die Bulk-Rückelektrode und die Kontaktschicht Molybdän oder Wolfram oder eine Molybdän- oder Wolframlegierung, insbesondere Molybdän oder eine Molybdänlegierung, enthalten oder im Wesentlichen aus Molybdän oder Wolfram oder einer Molybdän- oder Wolframlegierung, insbesondere Molybdän oder einer Molybdänlegierung, gebildet sind.

Geeignet sind in diesem Zusammenhang auch solche Ausführungsformen, bei denen die Bulk-Rückelektrodenschicht enthält oder im Wesentlichen gebildet ist aus Molybdän und/oder Wolfram, insbesondere Molybdän, und dass die Kontaktschicht enthält oder im Wesentlichen gebildet ist aus Titan.

Das Behandeln der Metalllage, d. h. der ersten Lage der Kontaktschicht, erfolgt vorzugsweise vor und/oder während der Halbleiterabsorberbildung einer Dünnschichtsolarzelle.

In einer möglichen Ausgestaltung kann dabei die Metalllage bei der Abscheidung aus einer Metallquelle, beispielsweise einer Molybdän- und/oder Wolframquelle, so dünn gewählt sein und/oder die Exposition unter Temperatur und Chalkogen, z.B. Selen oder Selenwasserstoff, so ausgeprägt gewählt sein, dass die Metalllage vollständig in eine Einschicht-Metallchalkogenidschicht überführt wird. Hierfür ist eine Dicke der Metalllage im Bereich von 2 nm bis 50 nm, insbesondere von 5 nm bis 10 nm, ausreichend und auch vorteilhaft. Die vollständige Überführung in eine Metallchalkogenidschicht gelingt dann besonders einfach und mit definiertem Reaktionsstopp, wenn die Metalllage zur Bildung der Kontaktschicht auf der leitfähigen Barriereschicht abgeschieden worden ist.

Auch solche Mehrschicht-Rückelektroden haben sich als besonders geeignet erwiesen, bei denen das Behandeln der Metalllage (erste Lage) vor und/oder während der Halbleiterabsorberbildung einer Dünnschichtsolarzelle erfolgt.

Hierbei kann unter anderem auch vorgesehen sein, dass der Dotierstoff, insbesondere Natriumionen, in der Kontaktschicht in einer Dosis im Bereich von 10¹³ bis 10¹⁷ Atomen/cm² bevorzugt in einer Dosis im Bereich von 10¹⁴ bis 10¹⁶ Atomen/cm²vorliegt.

Die der Erfindung zugrunde liegende Aufgabe wird ferner gelöst durch eine photovoltaische Dünnschichtsolarzelle bzw. ein photovoltaisches Dünnschichtsolarmodul, umfassend mindestens eine erfindungsgemäße Mehrschicht-Rückelektrode.

Geeignete erfindungsgemäße Dünnschichtsolarzellen bzw. -Module umfassen z. B., in dieser Reihenfolge, mindestens eine Substratschicht, mindestens eine erfindungsgemäße Rückelektrodenschicht, mindestens eine, insbesondere an der Kontaktschicht unmittelbar anliegende, Halbleiterabsorberschicht, insbesondere Chalkopyrit- oder Kesterit-Halbleiterabsorberschicht, und mindestens eine Frontelektrode.

Weitere Ausführungsformen solcher Dünnschichtsolarzellen und -Module zeichnen sich dadurch aus, dass zwischen der Halbleiterabsorberschicht und der Frontelektrode mindestens eine Pufferschicht, insbesondere mindestens eine Schicht, enthaltend oder im Wesentlichen gebildet aus CdS oder einer CdS-freien Schicht, insbesondere enthaltend oder im Wesentlichen aus Zn(S,OH) oder In₂S₃, und/oder mindestens eine Schicht, enthaltend und im Wesentlichen gebildet aus intrinsischem Zinkoxid und/oder hochohmigem Zinkoxid, vorliegt.

Hierbei kann auch vorgesehen sein, dass mindestens eine leitfähige Barriereschicht zwischen der Rückelektrodenschicht und der Kontaktschicht vorliegt.

Gemäß einer möglichen Ausgestaltung der erfindungsgemäßen Dünnschichtsolarzelle bzw. des erfindungsgemäßen Dünnschichtsolarmoduls kann die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ, Sₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellen oder umfassen, wobei x beliebige Werte von 0 bis 1 annimmt. Den Kesterit-Schichten liegt in der Regel eine IB-IIA-IVA-VIA-Struktur zugrunde. Exemplarisch seien Cu₂ZnSnSe₄ und Cu₂ZnSnS₄ genannt.

In einer weiteren Ausgestaltung kann vorgesehen sein, dass die Kontaktschicht mindestens eine Metallschicht und mindestens eine Metallchalkogenidschicht umfasst, wobei erstere zu der Rückelektrode benachbart ist bzw. an diese angrenzt oder zu der Barriereschicht benachbart ist bzw. an diese angrenzt, und letztere zu der Halbleiterabsorberschicht benachbart ist bzw. an diese angrenzt.

Bevorzugt sind auch solche Dünnschichtsolarzellen und -module, bei denen die Metallschicht und die Metallchalkogenidschicht auf dem gleichen Metall, insbesondere Molybdän und/oder Wolfram, basieren. Besonders bevorzugt stellt hierbei die Kontaktschicht eine Metallchalkogenidschicht dar.

Erfindungsgemäße photovoltaische Dünnschichtsolarmodule enthalten vorzugsweise mindestens zwei, insbesondere eine Vielzahl an, insbesondere monolithisch integrierten serienverschalteten, erfindungsgemäßen Dünnschichtsolarzellen. Beispielsweise können in einem erfindungsgemäßen Dünnschichtsolarmodul 20 bis 150 oder 50 bis 100 serienverschaltete erfindungsgemäße Dünnschichtsolarzellen vorliegen.

Der spezifische Gesamtwiderstand der erfindungsgemäßen Mehrschicht-Rückelektrode sollte in einer geeigneten Ausgestaltung nicht über 50 microOhm*cm liegen, bevorzugt nicht über 10 microOhm^{∗}cm. Auf diese Weise soll eine möglichst verlustarme, monolithisch integrierte Serienverschaltung sichergestellt werden können.

Das erfindungsgemäße Verfahren zur Herstellung einer Mehrschicht-Rückelektrode zeichnet sich in einer Ausführungsform dadurch aus, dass es die folgenden schritte umfasst:
Applizieren der Bulk-Rückelektrodenschicht, der Barrierenschicht, der Kontaktschicht, der Metalle der Halbleiterabsorberschicht und/oder des/der Dotierstoffe mittels physikalischer Dünnschicht-Abscheideverfahren, insbesondere umfassend Physical Vapor Deposition (PVD)- Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron- Sputtern, jeweils vorzugsweise in einem Hochvakuum, oder mittels chemischer Gasphasenabscheidung, insbesondere umfassend Chemical Vapour Deposition (CVD), Niedrigdruck- (low pressure) CVD und/oder Atmosphären- (atmospheric pressure).

Hierbei kann erfindungsgemäß vorgesehen sein, dass die Bulk-Rückelektrodenschicht, die Barrierenschicht, die Kontaktschicht, die Metalle der Halbleiterabsorberschicht und/oder der/die Dotierstoffe mittels Kathodenzerstäubung (Sputter-Beschichtung), insbesondere DC- Magnetron-Sputterns, appliziert werden.

Von Vorteil ist auch eine solche Verfahrensvariante, bei der der/die Dotierstoffe zusammen mit mindestens einer Komponente der Kontaktschicht und/oder der Absorberschicht, insbesondere aus einem Misch- oder Sintertarget, appliziert werden. Schließlich kann vorgesehen sein, dass das Misch- oder Sintertarget mindestens einen Dotierstoff, insbesondere ausgewählt aus einer Natriumverbindung, Natriumionen, einer Natrium-Molybdän-Bronze und/oder einer Natrium-Wolfram-Bronze, insbesondere in einer Matrix-Komponente, ausgewählt aus MoSe₂, WSe₂, Mo, W, Kupfer und/oder Gallium enthält. Beispielsweise kann ein Molybdänselenid-Target mit Natriumsulfit als Dotierstoff versetzt sein.

Mit der vorliegenden Erfindung geht die überraschende Erkenntnis einher, dass sich mit Aufbau der erfindungsgemäßen Mehrschicht-Rückelektrode relativ dünne Schichtdicken der Halbleiterabsorberschicht in Dünnschichtsolarzellen bzw. -modulen realisieren lassen, ohne Wirkungsgradverluste in Kauf nehmen zu müssen. Mit den erfindungsgemäßen Systemen stellen sich häufig sogar höhere Wirkungsgrade ein. Diesbezüglich wurde gefunden, dass die das Sonnenlicht reflektierenden Barriereschichten zu einer weiteren Stromgenerierung beitragen. Das Sonnenlicht passiert hier die Halbleiterabsorberschicht zweimal.
Überraschend wurde ferner gefunden, dass eine verbesserte Wirkung auch damit einhergeht, dass die Halbleiterabsorberschicht, z.B. auf Basis eines Chalkopyrit- oder Kesterit- Systems, unmittelbar auf einer Molybdän-Kontaktschicht abgeschieden wird. Diese kann hierbei im sich anschließenden Halbleiter-Bildungsprozess an der Grenzfläche zu Molybdänselenid oder -sulfoselenid reagieren. Ferner wurde überraschend gefunden, dass sich Dotierstoffe für die Halbleiterabsorberschicht, beispielsweise auf Basis von Natrium, wohl dosiert über die Kontaktschicht, d.h. ursprünglich in der Kontaktschicht vorliegend, in die genannte Halbleiterabsorberschicht einbringen lassen. Hierfür reichen schon die Temperaturen bei der Bildung der Halbleiterabsorberschicht aus, wobei unterstützend die Barriereschicht die Wanderungsrichtung der Dotierstoffe in Richtung der Halbleiterabsorberschicht mit beeinflusst. Die genannten Dotierstoffe, sobald in der Halbleiterabsorberschicht vorliegend, tragen regelmäßig zur Erhöhung des Wirkungsgrads einer Dünnschichtsolarzelle bzw. eines -moduls bei. Hierbei hat sich als vorteilhaft herausgestellt, dass sich über den Eintrag über die Kontaktschicht die Menge an Dotierstoff, die letztendlich im fertig gestellten Produkt in der Halbleiterabsorberschicht vorliegt, sehr genau einstellen lässt. Erst auf diese Weise gelingt eine reproduzierbare Erhöhung des Wirkungsgrades unabhängig von der Zusammensetzung des Glases und/oder der Bulk-Rückelektrode. Mit den erfindungsgemäßen Systemen lassen sich überraschender Weise auch Wirkungsgradverluste durch unkontrollierte Reaktionen des Chalkogens, insbesondere Selens, während der Bildung der Halbleiterabsorberschicht mit der Bulk-Rückelektrode vermeiden. Indem es auf der Oberfläche der Bulk-Rückelektrode nicht mehr zu einer Bildung von Metallchalkogeniden, wie Molybdänselenid, kommt, wird auch ein Verlust an Leitfähigkeit der Bulk-Rückelektrode sowie eine lateral inhomogene Chalkogenidbildung vermieden und damit die Bildung von Mikrorissen unterbunden. Denn mit der Chalkonidbildung geht regelmäßig eine beträchtliche Volumenexpansion einher. Mit den erfindungsgemäßen Systemen ist es z.B. möglich, die Dicke der einzelnen Schichten wie auch die Dicke des Gesamtsystems genauer und zuverlässiger einzustellen als bei herkömmlichen Dünnschichtsystemen. Gleichzeitig erlauben die erfindungsgemäßen Mehrschicht-Rückelektroden die Verwendung von verunreinigtem Bulk-Rückelektrodenmaterial, ohne dass der Wirkungsgrad der Dünnschichtsolarzelle nachteilig beeinflusst wird. Hiermit lassen sich die Gesamtkosten eines Dünnschichtsolarmoduls merklich reduzieren. Ferner findet mit den erfindungsgemäßen Mehrschicht-Rückelektroden ein wesentlich kontrollierterer Aufbau der Halbleiterabsorberschicht statt. Bestandteile des Halbleiters wie Cu, In und/oder Ga wandern nicht mehr in die Rückelektrode ab, wodurch das gewünschte Massenverhältnis der die Halbleiterabsorberschicht bildenden Komponenten gezielter eingestellt und auch gehalten werden kann.

Des Weiteren erlaubt die erfindungsgemäße Mehrschicht-Rückelektrode den gezielten Aufbau einer sehr dünnen Kontaktschicht, die selbst wenn als Metallchalkonid vorliegend keine Unebenheiten zeigt und mit der keine Haftungsprobleme einhergehen.

Weitere Merkmale und Vorteile der Erfindung ergeben sich aus der nachgehenden Beschreibung, in der bevorzugte Ausführungsformen der Erfindung beispielhaft anhand schematischer Zeichnungen erläutert sind. Dabei zeigen:
- Figur 1: eine schematische Querschnittsansicht durch ein Teilsystem einer Dünnschichtsolarzelle, enthaltend eine erste Ausführungsform einer erfindungsgemäßen Mehrschicht-Rückelektrode;
- Figur 2: eine schematische Querschnittsansicht durch ein Teilsystem einer Dünnschichtsolarzelle, enthaltend eine zweite Ausführungsform einer erfindungsgemäßen Mehrschicht-Rückelektrode; und
- Figur 3: eine schematische Querschnittsansicht durch ein Teilsystem einer erfindungsgemäßen Dünnschichtsolarzelle.

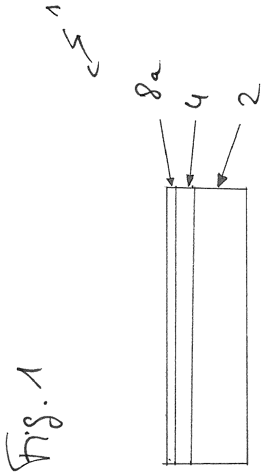

Auf der Substratschicht 2, beispielsweise einem Glassubstrat, liegt in der in Figur 1 abgebildeten Ausführungsform einer erfindungsgemäßen Mehrschicht-Rückelektrode 1 eine Bulk-Rückelektrodenschicht 4 aus Molybdän vor. Hierauf aufliegend befindet sich eine Ohm'sche Kontaktschicht 8a, erhalten durch Auftragen mindestens einer Lage im Wesentlichen aus Molybdänselenid mittels physikalischer Gasphasenabscheidung unter Verwendung mindestens eines Molybdänselenidtargets. Hieran kann optional (nicht abgebildet) eine bidirektional wirkende leitfähige Barriereschicht aus zum Beispiel Wolframnitrid oder Titannitrid angrenzen. Die Kontaktschicht 8a ist dabei in einer bevorzugten Ausführungsform mit mindestens einem Dotierstoff versetzt sein, beispielsweise Natriumionen oder einer Natriumverbindung, insbesondere Natriumsulfit oder Natriumsulfid. Die derart dotierte Kontaktschicht kann dadurch erhalten werden, dass der Dotierstoff, beispielsweise Natriumsulfit, dem Molybdäntarget beigemengt war. In einer besonders zweckmäßigen alternativen Ausführungsform stimmen die Bulk-Rückelektrode und die Kontaktschicht hinsichtlich der verwendeten Metalle nicht überein. Beispielsweise kommt für die Bulk-Rückelektrode Titan zum Einsatz, während für die Kontaktschicht Molybdän bzw. Molybdänselenid verwendet wird.

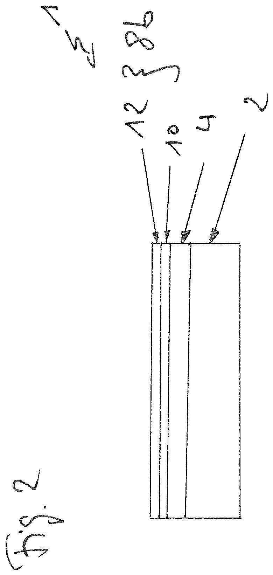

In der in Figur 2 wiedergegebenen zweiten Ausführungsform einer erfindungsgemäßen Mehrschicht-Rückelektrode 1 stellt die Kontaktschicht 8b ein Zweischichtsystem dar aus einer ersten Lage 10 aus einem Metall, beispielsweise Molybdän oder Wolfram, und einer zweiten Lage 12 aus einem Metallchalkogenid, beispielsweise Molybdänselenid und/oder Wolframselenid, das an die erste Lage 10 angrenzt. Auch bei dieser Ausführungsform liegt in der Kontaktschicht 8b bevorzugt mindestens ein Dotierstoff vor, beispielsweise Natriumionen oder einer Natriumverbindung, insbesondere Natriumsulfit oder Natriumsulfid. Hierbei kann der Dotierstoff in der ersten und/oder der zweiten Lage zugegen sein. Dieses Zweischichtsystem kann dadurch erhalten werden, dass zunächst mittels physikalischer Gasphasenabscheidung unter Verwendung mindestens einer Molybdän- und/oder Wolframquelle eine Metalllage abgeschieden wird. Anschließend wird die Metalllage bei Temperaturen oberhalb von 300°C, vorzugsweise oberhalb von 350°C, in einer Selen- oder Selenwasserstoffatmosphäre unter Ausbildung zweier Schichten nur partiell, d.h. an der zur Rückelektrode abgewandten Seite in das Metallselenid, beispielsweise Molybdänselenid umgewandelt. Optional kann (nicht abgebildet) eine bidirektional wirkende leitfähige Barriereschicht aus zum Beispiel Wolframnitrid oder Titannitrid zwischen der Bulk-Rückelektrodenschicht und der Kontaktschicht vorgesehen sein.

In einer besonders zweckmäßigen alternativen Ausführungsform stimmen die Bulk-Rückelektrode und die Kontaktschicht hinsichtlich der verwendeten Metalle nicht überein.

Beispielsweise kommt für die Bulk-Rückelektrode Titan zum Einsatz, während für die Kontaktschicht Molybdän bzw. Molybdänselenid verwendet wird.

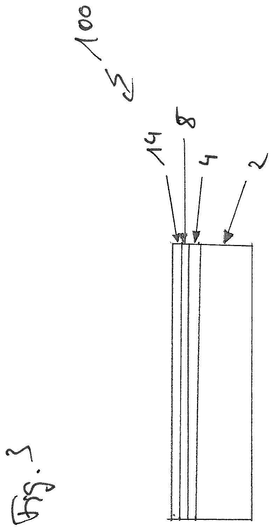

Die in Figur 3 in Teilen wiedergegebene erfindungsgemäße Dünnschichtsolarzelle 100 verfügt über eine Substratschicht 2 aus Glas, eine Bulk-Rückelektrodenschicht 4 aus z.B. Mo, W oder Ti, eine Kontaktschicht 8 aus Molybdänselenid und eine Chalkopyrit-Halbleiterabsorberschicht 14. Diese ist dadurch erhalten worden, dass zunächst eine Metalllage aus Molybdän auf der Rückelektrodenschicht aufgebracht wurde. Optional kann (nicht abgebildet) eine bidirektional wirkende leitfähige Barriereschicht aus zum Beispiel Wolframnitrid oder Titannitrid zwischen der Bulk-Rückelektrodenschicht und der Kontaktschicht vorgesehen sein. Anschließend wurden die Metalle der Halbleiterabsorberschicht hierauf appliziert, welche sodann einer Selen- und/oder Schwefelatmosphäre und/oder einer H₂S- und/oder H₂Se-Atmosphäre zwecks Ausbildung der Chalkopyritstruktur ausgesetzt wurden. Nach Bildung dieser Chalkopyritstruktur wurde die genannte Chalkogenatmosphäre aufrecht erhalten, vorzugsweise bei Temperaturen oberhalb von 350°C, mit der Folge, dass nun auch die darunter liegende Metalllage in das entsprechende Metallchalkogenid umgewandelt wurde. Auch hier stimmen in einer besonders zweckmäßigen alternativen Ausführungsform die Bulk-Rückelektrode und die Kontaktschicht hinsichtlich der verwendeten Metalle nicht überein. Beispielsweise kann für die Bulk-Rückelektrode Titan eingesetzt werden, während für die Kontaktschicht Molybdän bzw. Molybdänselenid verwendet wird.

Die in der vorstehenden Beschreibung, in den Ansprüchen sowie in den Zeichnungen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zu Herstellung einer Mehrschicht-Rückelektrode (1) für eine photovoltaische Dünnschichtsolarzelle, wobei die Mehrschicht-Rückelektrode (1) umfasst, in dieser Reihenfolge,
mindestens eine Bulk-Rückelektrodenschicht (4),
mindestens eine, insbesondere Ohm'sche, Kontaktschicht (8a, 8b),
**dadurch gekennzeichnet, dass**
die Kontaktschicht (8a, 8b) erhalten wird durch:
- Auftragen mindestens einer Lage enthaltend oder im Wesentlichen aus mindestens einem Metallchalkogenid mittels physikalischer oder chemischer Gasphasenabscheidung unter Verwendung mindestens einer Metallchalkogenidquelle, wobei das Metall des Metallchalkogenids ausgewählt ist aus Molybdän, Wolfram, Tantal, Cobalt, Zirconium und/oder Niob, insbesondere wobei das Chalkogen des Metallchalkogenids ausgewählt ist aus Selen und/oder Schwefel,
oder
- Auftragen mindestens einer Metalllage als erste Lage (10), wobei die erste Lage (10) und die Bulk-Rückelektrodenschicht (4) in dem jeweils verwendetem Metall oder, sofern mehrere Metalle in der Metalllage und der Bulk-Rückelektrodenschicht (4) vorliegen, hinsichtlich mindestens eines, insbesondere sämtlicher dieser Metalle, nicht übereinstimmen, enthaltend oder im Wesentlichen aus Mo, W, Ta, Nb, Zr und/oder Co mittels physikalischer Gasphasenabscheidung unter Verwendung mindestens einer Metallquelle und Behandeln dieser Metalllage bei Temperaturen oberhalb von 300°C in einer Chalkogenatmosphäre und/oder Chalkogenwasserstoffatmosphäre, insbesondere Selen- und/oder Schwefelatmosphäre und/oder H₂S- und/oder H₂Se- Atmosphäre, unter Ausbildung einer Metallchalkogenidlage als zweite Lage (12).

2. Verfahren nach Anspruch 1, **dadurch gekennzeichnet, dass**
das Metallchalkogenid MSe₂, MS₂ und/oder M(Se₁₋ₓ,Sₓ)₂ darstellt mit M = Mo, W, Ta, Zr, Co oder Niob und insbesondere ausgewählt ist aus der Gruppe bestehend aus MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ und/oder Nb(Se₁₋ₓ,Sₓ)₂, wobei x Werte von 0 bis 1 annimmt.

3. Verfahren nach Anspruch 1 oder 2, **dadurch gekennzeichnet, dass**
die Mehrschicht-Rückelektrode (1) mindestens eine leitfähige Barriereschicht, insbesondere bidirektionale Barriereschicht, umfasst, die zwischen der Bulk- Rückelektrodenschicht (4) und der Kontaktschicht (8a, 8b) vorliegt.

4. Verfahren nach Anspruch 3, **dadurch gekennzeichnet, dass**
die Barriereschicht eine Barriere für Alkaliionen, insbesondere Natriumionen, Selen oder Selenverbindungen, Schwefel oder Schwefelverbindungen, Metalle, insbesondere Cu, In, Ga, Fe, Ni, Al, Ti, Zr, Hf, V, Nb, Ta und/oder W, und/oder Verbindungen enthaltend Alkaliionen darstellt.

5. Verfahren nach Anspruch 3 oder 4, **dadurch gekennzeichnet, dass**
die Barriereschicht enthält oder im Wesentlichen gebildet ist aus mindestens einem Metallnitrid, insbesondere TiN, MoN, TaN, ZrN und/oder WN, mindestens einem Metallcarbid, mindestens einem Metallborid und/oder mindestens einem Metallsiliziumnitrid, insbesondere TiSiN, TaSiN und/oder WSiN.

6. Verfahren nach einem der vorangehenden Ansprüche, **dadurch gekennzeichnet, dass**
die Bulk-Rückelektrodenschicht (4) enthält oder im Wesentlichen gebildet ist aus V, Mn, Cr, Mo, Ti, Co, Zr, Ta, Nb und/oder W und/oder enthält oder im Wesentlichen gebildet ist aus einer Legierung enthaltend V, Mn, Cr, Mo, Ti, Co, Fe, Ni, Al, Zr, Ta, Nb und/oder W.

7. Verfahren nach einem der vorangehenden Ansprüche, **dadurch gekennzeichnet, dass**
die Bulk-Rückelektrodenschicht (4) verunreinigt ist mit mindestens einem Element ausgewählt aus der Gruppe bestehend aus Fe, Ni, Al, Ti, Zr, Hf, V, Nb, Ta, W und/oder Na und/oder mit Verbindungen der genannten Elemente.

8. Verfahren nach einem der vorangehenden Ansprüche, **dadurch gekennzeichnet, dass**
das Metall der ersten Lage und das Metall der zweiten Lage der Kontaktschicht (8a, 8b) übereinstimmen und/oder dass das Metall der ersten Lage und/oder das Metall der zweiten Lage der Kontaktschicht (8a, 8b) mit dem Metall der Bulk-Rückelektrodenschicht (4) übereinstimmen.

9. Verfahren nach einem der vorangehenden Ansprüche, **dadurch gekennzeichnet, dass**
die Kontaktschicht (8a, 8b), die erste und/oder die zweite Lage der Kontaktschicht (8a, 8b) mindestens einen Dotierstoff für eine Halbleiterabsorberschicht einer Dünnschichtsolarzelle, insbesondere mindestens ein Element ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist.

10. Verfahren nach einem der vorangehenden Ansprüche, **dadurch gekennzeichnet, dass**
die physikalische Gasphasenabscheidung umfasst Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF- Magnetron-Sputtern, jeweils vorzugsweise in einem Hochvakuum, und dass die chemische Gasphasenabscheidung umfasst Chemical Vapour Deposition (CVD), Niedrigdruck- (low pressure) CVD und/oder Atmosphären- (atmospheric pressure) CVD.

11. Verfahren nach einem der vorangehenden Ansprüche, **dadurch gekennzeichnet, dass**
die durchschnittliche Dicke der Bulk-Rückelektrodenschicht (4) im Bereich von 50 nm bis 500 nm, insbesondere im Bereich von 80 nm bis 250 nm, und/oder der Barriereschicht im Bereich von 10 nm bis 250 nm, insbesondere im Bereich von 20 nm bis 150 nm, und/oder der Kontaktschicht (8a, 8b) im Bereich von 2 nm bis 200 nm, insbesondere im Bereich von 5 nm bis 100 nm, liegt.

12. Verfahren nach einem der vorangehenden Ansprüche, **dadurch gekennzeichnet, dass**
die Bulk-Rückelektrodenschicht (4) und die Kontaktschicht (8a, 8b) Molybdän oder Wolfram oder eine Molybdän- oder Wolframlegierung, insbesondere Molybdän oder eine Molybdänlegierung, enthalten oder im Wesentlichen aus Molybdän oder Wolfram oder einer Molybdän- oder Wolframlegierung, insbesondere Molybdän oder einer Molybdänlegierung, gebildet sind, und/oder dass die Bulk-Rückelektrodenschicht (4) enthält oder im Wesentlichen gebildet ist aus Molybdän und/oder Wolfram, insbesondere Molybdän, und dass die Kontaktschicht (8a, 8b) enthält oder im Wesentlichen gebildet ist aus Titan.

13. Verfahren nach einem der vorangehenden Ansprüche, **dadurch gekennzeichnet, dass**
das Behandeln der Metalllage (erste Lage) vor und/oder während der Halbleiterabsorberbildung einer Dünnschichtsolarzelle erfolgt.

14. Verfahren nach einem der vorangehenden Ansprüche, **dadurch gekennzeichnet, dass**
die Bulk-Rückelektrodenschicht (4) Molydän und/oder Wolfram, insbesondere Molybdän, enthält oder im Wesentlichen aus Molydän und/oder Wolfram, insbesondere Molybdän, gebildet ist, die leitfähige Barriereschicht TiN enthält oder im Wesentlichen aus TiN gebildet ist, und
die, insbesondere Dotierstoff(e) enthaltende, Kontaktschicht (8a, 8b) MoSe₂ enthält oder im Wesentlichen aus MoSe₂ gebildet ist.

15. Verfahren nach einem der Ansprüche 9 bis 14, **dadurch gekennzeichnet, dass**
der Dotierstoff, insbesondere Natriumionen, in der Kontaktschicht (8a, 8b) in einer Konzentration im Bereich von 10¹⁴ bis 10¹⁷ Atomen/cm², insbesondere im Bereich von 10¹⁴ bis 10¹⁶ Atomen/cm² vorliegt.

16. Mehrschicht-Rückelektrode (1) erhalten nach dem Verfahren einer der vorangehenden Ansprüche, insbesondere nach einem der Ansprüche 3-5, 8-9 und 12-15,
wobei die Mehrschicht-Rückelektrode (1) umfasst, in dieser Reihenfolge,
mindestens eine Bulk-Rückelektrodenschicht (4),
mindestens eine, insbesondere Ohm'sche, Kontaktschicht (8a, 8b),
**dadurch gekennzeichnet, dass**
die Kontaktschicht (8a, 8b) erhalten wird durch:
- Auftragen mindestens einer Lage enthaltend oder im Wesentlichen aus mindestens einem Metallchalkogenid mittels physikalischer oder chemischer Gasphasenabscheidung unter Verwendung mindestens einer Metallchalkogenidquelle, wobei das Metall des Metallchalkogenids ausgewählt ist aus Molybdän, Wolfram, Tantal, Cobalt, Zirconium und/oder Niob, insbesondere wobei das Chalkogen des Metallchalkogenids ausgewählt ist aus Selen und/oder Schwefel,
oder
- Auftragen mindestens einer Metalllage als erste Lage (10), wobei die erste Lage (10) und die Bulk-Rückelektrodenschicht (4) in dem jeweils verwendetem Metall oder, sofern mehrere Metalle in der Metalllage und der Bulk-Rückelektrodenschicht (4) vorliegen, hinsichtlich mindestens eines, insbesondere sämtlicher dieser Metalle, nicht übereinstimmen, enthaltend oder im Wesentlichen aus Mo, W, Ta, Nb, Zr und/oder Co mittels physikalischer Gasphasenabscheidung unter Verwendung mindestens einer Metallquelle und Behandeln dieser Metalllage bei Temperaturen oberhalb von 300°C in einer Chalkogenatmosphäre und/oder Chalkogenwasserstoffatmosphäre, insbesondere Selen- und/oder Schwefelatmosphäre und/oder H₂S- und/oder H₂Se- Atmosphäre, unter Ausbildung einer Metallchalkogenidlage als zweite Lage (12).

17. Mehrschicht-Rückelektrode (1) nach Anspruch 16, wobei die durchschnittliche Dicke der Kontaktschicht (8a, 8b) im Bereich von 100 nm bis 200 nm liegt.

18. Photovoltaische Dünnschichtsolarzelle, umfassend mindestens eine Mehrschicht- Rückelektrode erhalten nach dem Verfahren gemäß einem der Ansprüche 1 bis 15.

19. Dünnschichtsolarzelle nach Anspruch 18, umfassend, in dieser Reihenfolge, mindestens eine Substratschicht (2), mindestens eine Rückelektrodenschicht erhalten nach dem Verfahren gemäß einem der Ansprüche 1 bis 15, mindestens eine, insbesondere Ohm'sche, Kontaktschicht (8a, 8b), mindestens eine, insbesondere an der Kontaktschicht (8a, 8b) unmittelbar anliegende, Halbleiterabsorberschicht (14), insbesondere Chalkopyrit- oder Kesterit-Halbleiterabsorberschicht, und mindestens eine Frontelektrode.

20. Dünnschichtsolarzelle nach Anspruch 18 oder 19, **dadurch gekennzeichnet, dass**
zwischen der Halbleiterabsorberschicht (14) und der Frontelektrode mindestens eine Pufferschicht, insbesondere mindestens eine Schicht, enthaltend oder im Wesentlichen gebildet aus CdS oder einer CdS-freien Schicht, insbesondere enthaltend oder im Wesentlichen aus Zn(S,OH) oder In₂S₃, und/oder mindestens eine Schicht, enthaltend und im Wesentlichen gebildet aus intrinsischem Zinkoxid und/oder hochohmigem Zinkoxid, vorliegt.

21. Dünnschichtsolarzelle nach einem der Ansprüche 18 bis 20, **dadurch gekennzeichnet, dass**
mindestens eine leitfähige Barriereschicht, insbesondere bidirektionale Barriereschicht, die zwischen der Rückelektrodenschicht und der Kontaktschicht (8a, 8b) vorliegt.

22. Dünnschichtsolarzelle nach einem der Ansprüche 18 bis 21, **dadurch gekennzeichnet, dass**
die Halbleiterabsorberschicht (14) eine quaternäre IB-IIIA-VIA-Chalkopyritschicht, insbesondere eine Cu(In,Ga)Se₂-Schicht, eine penternäre IB-1IIA-VIA- Chalkopyritschicht, insbesondere eine Cu(In,Ga)(Seₓ,S₁₋ₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x Werte von 0 bis 1 annimmt.

23. Dünnschichtsolarzelle nach einem der Ansprüche 18 bis 22, **dadurch gekennzeichnet, dass**
die Kontaktschicht (8a, 8b) mindestens eine Metallschicht und mindestens eine Metallchalkogenidschicht umfasst, wobei erstere zu der Rückelektrode benachbart ist bzw. an diese angrenzt oder zu der Barriereschicht benachbart ist bzw. an diese angrenzt, und letztere zu der Halbleiterabsorberschicht benachbart ist bzw. an diese angrenzt.

24. Photovoltaisches Dünnschichtsolarmodul, enthaltend mindestens zwei, insbesondere eine Vielzahl an, insbesondere monolithisch integrierten serienverschalteten, Dünnschichtsolarzellen nach einem der Ansprüche 18 bis 23.

25. Verwendung der Dünnschichtsolarzelle gemäß einem der Ansprüche 18 bis 23 für die Herstellung photovoltaischer Dünnschichtsolarmodule.

26. Verwendung der Mehrschicht-Rückelektrode (1) erhalten nach dem Verfahren gemäß einem der Ansprüche 1 bis 15 für die Herstellung von photovoltaischen Dünnschichtsolarzellen oder Dünnschichtsolarmodulen.

27. Verwendung der Mehrschicht-Rückelektrode (1) erhalten nach dem Verfahren gemäß einem der Ansprüche 9 bis 15 für die Dotierung einer Halbleiterabsorberschicht (14) während der Herstellung einer photovoltaischen Dünnschichtsolarzelle, insbesondere gemäß einem der Ansprüche 18 bis 23, oder eines photovoltaischen Dünnschichtmoduls, insbesondere gemäß Anspruch 24.

28. Verfahren nach einem der Ansprüche 1 bis 15 zur Herstellung einer Mehrschicht-Rückelektrode, umfassend die Schritte:
Applizieren der Bulk-Rückelektrodenschicht (4), der Barriereschicht nach Anspruch 3, der Kontaktschicht (8a, 8b), der Metalle der Halbleiterabsorberschicht (14) nach Anspruch 9 und/oder von Dotierstoffen, mittels physikalischer Dünnschicht-Abscheideverfahren, insbesondere umfassend Physical Vapor Deposition (PVD)-Beschichtung, Aufdampfen mittels eines Elektronenstrahl- Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mittels chemischer Gasphasenabscheidung, insbesondere umfassend Chemical Vapour Deposition (CVD), Niedrigdruck- (low pressure) CVD und/oder Atmosphären-(atmospheric pressure).

29. Verfahren nach Anspruch 28, **dadurch gekennzeichnet, dass**
die Bulk-Rückelektrodenschicht (4), die Barriereschicht, die Kontaktschicht (8a, 8b), die Metalle der Halbleiterabsorberschicht (14) und/oder der/die Dotierstoffe mittels Kathodenzerstäubung (Sputter-Beschichtung), insbesondere DC-Magnetron- Sputterns, appliziert werden.

30. Verfahren nach Anspruch 28 oder 29, **dadurch gekennzeichnet, dass**
der/die Dotierstoffe, insbesondere ausgewählt aus einer Natriumverbindung, Natriumionen, einer Natrium-Molybdän-Bronze und/oder einer Natrium-Wolfram- Bronze, zusammen mit mindestens einer Komponente der Kontaktschicht (8a, 8b) und/oder der Absorberschicht, insbesondere aus einem Misch- oder Sintertarget, appliziert werden.

## Claims

1. A method for the production of a multi-layer back electrode (1) for a photovoltaic thin-film solar cell, wherein the multi-layer back electrode (1) comprises, in this order,
at least one bulk back electrode layer (4),
at least one, in particular ohmic, contact layer (8a, 8b),
**characterized in that**
the contact layer (8a, 8b) is obtained by:
- application of at least one layer containing or composed substantially of at least one metal chalcogenide by means of physical or chemical gas-phase deposition using at least one metal chalcogenide source, wherein the metal of the metal chalcogenide is selected from molybdenum, tungsten, tantalum, cobalt, zirconium and/or niobium, in particular wherein the chalcogen of the metal chalcogenide is selected from selenium and/or sulfur,
or
- application of at least one metal layer as first layer (10), wherein the first layer (10) and the bulk back electrode layer (4) do not correspond in terms of the respectively used metal or, where a plurality of metals are present in the metal layer and the bulk back electrode layer (4), in terms of at least one, in particular all of these metals, containing or composed substantially of Mo, W, Ta, Nb, Zr and/or Co by means of physical gas-phase deposition using at least one metal source and treatment of this metal layer at temperatures of above 300°C in a chalcogen atmosphere and/or chalcogen-hydrogen atmosphere, in particular selenium and/or sulfur atmosphere and/or H₂S and/or H₂Se atmosphere, forming a metal chalcogenide layer as second layer (12).

2. The method according to Claim 1, **characterized in that**
the metal chalcogenide is MSe₂, MS₂ and/or M(Se₁₋ₓ,Sₓ)₂, with M = Mo, W, Ta, Zr, Co or niobium, and in particular is selected from the group consisting of MoSe₂, WSe₂, TaSe₂, NbSe₂, Mo(Se₁₋ₓ,Sₓ)₂, W(Se_{1-x,}Sₓ)₂, Ta(Se₁₋ₓ,Sₓ)₂ and/or Nb(Se₁₋ₓ,Sₓ)₂, wherein x assumes values of 0 to 1.

3. The method according to Claim 1 or 2, **characterized in that**
the multi-layer back electrode (1) comprises at least one conductive barrier layer, in particular bidirectional barrier layer, which is present between the bulk back electrode layer (4) and the contact layer (8a, 8b).

4. The method according to Claim 3, **characterized in that**
the barrier layer is a barrier for alkali metal ions, in particular sodium ions, selenium or selenium compounds, sulfur or sulfur compounds, metals, in particular Cu, In, Ga, Fe, Ni, Al, Ti, Zr, Hf, V, Nb, Ta and/or W, and/or compounds containing alkali metal ions.

5. The method according to Claim 3 or 4, **characterized in that**
the barrier layer contains or is substantially formed of at least one metal nitride, in particular TiN, MoN, TaN, ZrN and/or WN, at least one metal carbide, at least one metal boride and/or at least one metal silicon nitride, in particular TiSiN, TaSiN and/or WSiN.

6. The method according to any one of the preceding claims, **characterized in that**
the bulk back electrode layer (4) contains or is substantially formed of V, Mn, Cr, Mo, Ti, Co, Zr, Ta, Nb and/or W and/or contains or is substantially formed of an alloy containing V, Mn, Cr, Mo, Ti, Co, Fe, Ni, Al, Zr, Ta, Nb and/or W.

7. The method according to any one of the preceding claims, **characterized in that**
the bulk back electrode layer (4) is contaminated with at least one element selected from the group consisting of Fe, Ni, Al, Ti, Zr, Hf, V, Nb, Ta, W and/or Na and/or with compounds of the stated elements.

8. The method according to any one of the preceding claims, **characterized in that**
the metal of the first layer and the metal of the second layer of the contact layer (8a, 8b) correspond and/or **in that** the metal of the first layer and/or the metal of the second layer of the contact layer (8a, 8b) correspond with the metal of the bulk back electrode layer (4).

9. The method according to any one of the preceding claims, **characterized in that**
the contact layer (8a, 8b), the first and/or second layer of the contact layer (8a, 8b) has at least one dopant for a semiconductor absorber layer of a thin-film solar cell, in particular at least one element selected from the group comprising sodium, potassium and lithium and/or at least one compound of these elements, preferably with oxygen, selenium, sulfur, boron and/or halogens, e.g. iodine or fluorine, and/or at least one alkali metal bronze, in particular sodium and/or potassium bronze, preferably with a metal selected from molybdenum, tungsten, tantalum and/or niobium.

10. The method according to any one of the preceding claims, **characterized in that**
the physical gas-phase deposition comprises physical vapor deposition (PVD) coating, vapor deposition using an electron beam vapor deposition means, vapor deposition using a resistance vapor deposition means, induction vapor deposition, ARC vapor deposition and/or cathode sputtering (sputter coating), in particular DC or RF magnetron sputtering, in each case preferably in a high vacuum, and **in that** the chemical gas-phase deposition comprises chemical vapor deposition (CVD), low pressure CVD and/or atmospheric pressure CVD.

11. The method according to any one of the preceding claims, **characterized in that**
the average thickness of the bulk back electrode layer (4) lies in the range from 50 nm to 500 nm, in particular in the range from 80 nm to 250 nm, and/or of the barrier layer lies in the range from 10 nm to 250 nm, in particular in the range from 20 nm to 150 nm, and/or of the contact layer (8a, 8b) lies in the range from 2 nm to 200 nm, in particular in the range from 5 nm to 100 nm.

12. The method according to any one of the preceding claims, **characterized in that**
the bulk back electrode layer (4) and the contact layer (8a, 8b) contain molybdenum or tungsten or a molybdenum or tungsten alloy, in particular molybdenum or a molybdenum alloy, or are substantially formed from molybdenum or tungsten or a molybdenum or tungsten alloy, in particular molybdenum or a molybdenum alloy, and/or **in that** the bulk back electrode layer (4) contains or is substantially formed of molybdenum and/or tungsten, in particular molybdenum, and **in that** the contact layer (8a, 8b) contains or is substantially formed of titanium.

13. The method according to any one of the preceding claims, **characterized in that**
treatment of the metal layer (first layer) takes place before and/or during semiconductor absorber formation of a thin-film solar cell.

14. The method according to any one of the preceding claims, **characterized in that**
the bulk back electrode layer (4) contains molybdenum and/or tungsten, in particular molybdenum, or is substantially formed of molybdenum and/or tungsten, in particular molybdenum, the conductive barrier layer contains TiN or is substantially formed of TiN, and
the contact layer (8a, 8b), in particular containing dopant(s), contains MoSe₂ or is substantially formed of MoSe₂.

15. The method according to any one of Claims 9 to 14, **characterized in that**
the dopant, in particular sodium ions, is present in the contact layer (8a, 8b) in a concentration in the range from 10¹⁴ to 10¹⁷ atoms/cm² in particular in the range from 10¹⁴ to 10¹⁶ atoms/cm².

16. A multi-layer back electrode (1) obtained using the method according to any one of the preceding claims, in particular according to any one of Claims 3-5, 8-9 and 12-15,
wherein the multi-layer back electrode (1) comprises, in this order,
at least one bulk back electrode layer (4),
at least one, in particular ohmic, contact layer (8a, 8b),
**characterized in that**
the contact layer (8a, 8b) is obtained by:
- application of at least one layer containing or composed substantially of at least one metal chalcogenide by means of physical or chemical gas-phase deposition using at least one metal chalcogenide source, wherein the metal of the metal chalcogenide is selected from molybdenum, tungsten, tantalum, cobalt, zirconium and/or niobium, in particular wherein the chalcogen of the metal chalcogenide is selected from selenium and/or sulfur,
or
- application of at least one metal layer as first layer (10), wherein the first layer (10) and the bulk back electrode layer (4) do not correspond in terms of the respectively used metal or, where a plurality of metals are present in the metal layer and the bulk back electrode layer (4), in terms of at least one, in particular all of these metals, containing or composed substantially of Mo, W, Ta, Nb, Zr and/or Co by means of physical gas-phase deposition using at least one metal source and treatment of this metal layer at temperatures of above 300°C in a chalcogen atmosphere and/or chalcogen-hydrogen atmosphere, in particular selenium and/or sulfur atmosphere and/or H₂S and/or H₂Se atmosphere, forming a metal chalcogenide layer as second layer (12).

17. The multi-layer back electrode (1) according to Claim 16, wherein the average thickness of the contact layer (8a, 8b) lies in the range from 100 nm to 200 nm.

18. A photovoltaic thin-film solar cell, comprising at least one multilayer back electrode obtained using the method according to any one of Claims 1 to 15.

19. The thin-film solar cell according to Claim 18, comprising, in this order, at least one substrate layer (2), at least one back electrode layer obtained using the method according to any one of Claims 1 to 15, at least one, in particular ohmic, contact layer (8a, 8b), at least one semiconductor absorber layer (14), in particular a charcopyrite or kesterite semiconductor absorber layer, in particular directly adjoining the contact layer (8a, 8b), and at least one front electrode.

20. The thin-film solar cell according to Claim 18 or 19, **characterized in that**
at least one buffer layer, in particular at least one layer containing or substantially formed of CdS or a CdS-free layer, in particular containing or substantially formed of Zn(S,OH) or In₂S₃, and/or at least one layer containing and substantially formed of intrinsic zinc oxide and/or high-resistance zinc oxide, is present between the semiconductor absorber layer (14) and the front electrode.

21. The thin-film solar cell according to any one of Claims 18 to 20, **characterized in that**
at least one conductive barrier layer, in particular bidirectional barrier layer, is present between the back electrode layer and the contact layer (8a, 8b).

22. The thin-film solar cell according to any one of Claims 18 to 21, **characterized in that**
the semiconductor absorber layer (14) is or comprises a quaternary IB-IIIA-VIA chalcopyrite layer, in particular a Cu(In,Ga)Se₂ layer, a penternary IB-IIIA-VIA chalcopyrite layer, in particular a Cu(In,Ga)(Seₓ,S₁₋ₓ)₂ layer, or a kesterite layer, in particular a Cu₂ZnSn(Seₓ,S₁₋ₓ)₄ layer, for example a Cu₂ZnSn(Se)₄ or a Cu₂ZnSₙ(S)₄ layer, wherein x assumes values from 0 to 1.

23. The thin-film solar cell according to any one of Claims 18 to 22, **characterized in that**
the contact layer (8a, 8b) comprises at least one metal layer and at least one metal chalcogenide layer, wherein the former is adjacent the back electrode or adjoins it or is adjacent the barrier layer or adjoins it, and the latter is adjacent the semiconductor absorber layer or adjoins it.

24. A photovoltaic thin-film solar module, containing at least two, in particular a plurality of, in particular monolithically integrated, series-connected, thin-film solar cells according to any one of Claims 18 to 23.

25. Use of the thin-film solar cell according to any one of Claims 18 to 23 for the production of photovoltaic thin-film solar modules.

26. Use of the multi-layer back electrode (1) obtained using the method according to any one of Claims 1 to 15 for the production of photovoltaic thin-film solar cells or thin-film solar modules.

27. Use of the multi-layer back electrode (1) obtained using the method according to any one of Claims 9 to 15 for doping a semiconductor absorber layer (14) during production of a photovoltaic thin-film solar cell, in particular according to any one of Claims 18 to 23, or a photovoltaic thin-film module, in particular according to Claim 24.

28. The method according to any one of Claims 1 to 15 for the production of a multi-layer back electrode, comprising the steps of:
applying the bulk back electrode layer (4), the barrier layer according to Claim 3, the contact layer (8a, 8b), the metals of the semiconductor absorber layer (14) according to Claim 9 and/or dopants, using physical thin-film deposition methods, in particular comprising physical vapor deposition (PVD) coating, vapor deposition using an electron beam vapor deposition means, vapor deposition using a resistance vapor deposition means, induction vapor deposition, ARC vapor deposition and/or cathode sputtering (sputter coating), in particular DC or RF magnetron sputtering, in each case preferably in a high vacuum, or using chemical gas-phase deposition, in particular comprising chemical vapor deposition (CVD), low pressure CVD and/or atmospheric pressure CVD.

29. The method according to Claim 28, **characterized in that**
the bulk back electrode layer (4), the barrier layer, the contact layer (8a, 8b), the metals of the semiconductor absorber layer (14) and/or the dopant(s) are applied by cathode sputtering (sputter coating), in particular DC magnetron sputtering.

30. The method according to Claim 28 or 29, **characterized in that**
the dopant(s), in particular selected from a sodium compound, sodium ions, a sodium-molybdenum bronze and/or a sodium-tungsten bronze, is/are applied together with at least one component of the contact layer (8a, 8b) and/or of the absorber layer, in particular from a mixed or sintered target.

## Revendications

1. Procédé pour la fabrication d'une électrode arrière multicouche (1) pour une cellule photovoltaïque en couches minces, l'électrode arrière multicouche (1) comprenant, dans cet ordre,
au moins une couche d'électrode arrière en volume (4),
au moins une couche de contact (8a, 8b), en particulier ohmique,
**caractérisé en ce que**,
la couche de contact (8a, 8b) est obtenue par :
- application d'au moins une couche contenant ou essentiellement se composant d'au moins un chalcogénure métallique au moyen d'un dépôt physique ou chimique en phase vapeur avec utilisation d'au moins une source de chalcogénure métallique, le métal du chalcogénure métallique étant sélectionné parmi le groupe se composant de molybdène, tungstène, tantale, cobalt, zirconium et/ou niobium, le chalcogéne du chalcogénure métallique étant en particulier sélectionné parmi du sélénium et/ou du soufre,
ou
- application d'au moins une couche métallique comme première couche (10), la première couche (10) et la couche d'électrode arrière en volume (4) ne correspondant pas relativement au métal utilisé respectivement ou, pour autant que plusieurs métaux sont présents dans la couche métallique et la couche d'électrode arrière en volume (4), relativement à au moins un, en particulier à tous ces métaux, comprenant ou se composant essentiellement de Mo, W, Ta, Nb, Zr et/ou Co au moyen de dépôt physique en phase vapeur avec utilisation d'au moins une source métallique et traitement de cette couche métallique à des températures supérieures à 300 °C dans une atmosphère de chalcogéne et/ou une atmosphère de chalcogénure d'hydrogène, en particulier une atmosphère de sélénium et/ou de soufre et/ou une atmosphère H₂S et/ou H₂Se, avec formation d'une couche de chalcogénure métallique comme deuxième couche (12).

2. Procédé selon la revendication 1, **caractérisé en ce que**
le chalcogénure métallique représente MSe₂, MS₂ et/ou M(Se₁₋ₓ,Sₓ,)₂ avec M = Mo, W, Ta, Zr, Co ou Nb et en particulier est sélectionné parmi le groupe se composant de MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ et/ou Nb(Se₁₋ₓ,Sₓ)₂, x prenant des valeurs de 0 à 1.

3. Procédé selon la revendication 1 ou 2, **caractérisé en ce que**
l'électrode arrière multicouche (1) comprend au moins une couche barrière conductrice, en particulier une couche barrière bidirectionnelle, laquelle est située entre la couche d'électrode arrière en volume (4) et la couche de contact (8a, 8b).

4. Procédé selon la revendication 3, **caractérisé en ce que**
la couche barrière représente une barrière pour des ions alcalins, en particulier des ions sodium, du sélénium ou des composés de sélénium, du soufre ou des composés de soufre, des métaux, en particulier Cu, In, Ga, Fe, Ni, À la, Ti, Zr, Hf. V, Nb, Ta et/ou W, et/ou des composés comprenant des ions alcalins.

5. Procédé selon la revendication 3 ou 4, **caractérisé en ce que**
la couche barrière comprend, ou est essentiellement formée de, au moins un nitrure métallique, en particulier TiN, MoN, TaN, ZrN et/ou WN, au moins un carbure métallique, au moins un borure métallique et/ou au moins un nitrure de silicium métallique, en particulier TiSiN, TaSiN et/ou WSiN.

6. Procédé selon l'une quelconque des revendications précédentes, **caractérisé en ce que**
la couche d'électrode arrière en volume (4) comprend du, ou est essentiellement formée de, V, Mn, Cr, Mo, Ti, Co, Zr, Ta, Nb et/ou W et/ou comprend, et/ou est essentiellement formée de, un alliage comprenant du V, Mn, Cr, Mo, Ti, Co, Fe, Ni, AI, Zr, Ta, Nb et/ou W.

7. Procédé selon l'une quelconque des revendications précédentes, **caractérisé en ce que**
la couche d'électrode arrière en volume (4) est contaminée par au moins un élément sélectionné parmi le groupe se composant de Fe, Ni, Al, Ti, Zr, Hf, V, Nb, Ta, W et/ou Na et/ou par des composés des susdits éléments.

8. Procédé selon l'une quelconque des revendications précédentes, **caractérisé en ce que**
le métal de la première couche et le métal de la deuxième couche de la couche de contact (8a, 8b) correspondent et/ou **en ce que** le métal de la première couche et/ou le métal de la deuxième couche de la couche de contact (8a, 8b) correspondent au métal de la couche d'électrode arrière en volume (4).

9. Procédé selon l'une quelconque des revendications précédentes, **caractérisé en ce que**
la couche de contact (8a, 8b), la première et/ou la deuxième couche de la couche de contact (8a, 8b) présentent au moins un dopant pour une couche d'absorption semi-conductrice d'une cellule photovoltaïque en couches minces, en particulier au moins un élément sélectionné parmi le groupe se composant de sodium, potassium et lithium et/ou au moins un composé de ces éléments, de préférence avec l'oxygène, le sélénium, le soufre, le bore et/ou des halogènes, par exempte l'iode ou le fluor, et/ou au moins un bronze de métal alcalin, en particulier du bronze de sodium et/ou du bronze de potassium, de préférence avec un métal sélectionné parmi le groupe se composant de molybdène, tungstène, tantale et/ou niobium.

10. Procédé selon l'une quelconque des revendications précédentes, **caractérisé en ce que**
le dépôt physique en phase vapeur comprend le revêtement par dépôt physique en phase vapeur (PVD), l'évaporation par système d'évaporation par faisceau d'électrons, l'évaporation par système d'évaporation par résistance, l'évaporation par induction, l'évaporation par arc et/ou pulvérisation cathodique (sputtering), en particulier pulvérisation magnétron DC ou RF, respectivement de préférence sous vide poussé, et **en ce que** le dépôt chimique en phase vapeur comprend le dépôt chimique en phase vapeur (CVD), le CVD à basse pression (low pressure) et/ou le CVD à pression atmosphérique (atmospheric pressure).

11. Procédé selon l'une quelconque des revendications précédentes, **caractérisé en ce que**
l'épaisseur moyenne de la couche d'électrode arrière en volume (4) se trouve dans la plage de 50 à nm à 500 nm, en particulier dans la plage de 80 nm à 250 nm, et/ou celle de la couche barrière se trouve dans la plage de 10 nm à 250 nm, en particulier dans la plage de 20 nm à 150 nm, et/ou celle de la couche de contact (8a, 8b) se trouve dans la plage de 2 nm à 200 nm, en particulier dans la plage de 5 nm à 100 nm.

12. Procédé selon l'une quelconque des revendications précédentes, **caractérisé en ce que**
la couche d'électrode arrière en volume (4) et la couche de contact (8a, 8b) comprennent du molybdène ou du tungstène ou un alliage de molybdène ou de tungstène, en particulier du molybdène ou un alliage de molybdène, ou sont formées essentiellement de molybdène ou de tungstène ou d'un alliage de molybdène ou de tungstène, en particulier de molybdène ou d'un alliage de molybdène, et/ou **en ce que** la couche d'électrode arrière en volume (4) comprend du, ou est essentiellement formée de, molybdène et/ou tungstène, en particulier de molybdène, et **en ce que** la couche de contact (8a, 8b) comprend du, ou est essentiellement formée de, titane.

13. Procédé selon l'une quelconque des revendications précédentes, **caractérisé en ce que**
le traitement de la couche métallique (première couche) est effectué avant et/ou pendant la formation d'absorbeur semi-conducteur d'une cellule photovoltaïque en couches minces.

14. Procédé selon l'une quelconque des revendications précédentes, **caractérisé en ce que**
la couche d'électrode arrière en volume (4) comprend du molybdène et/ou du tungstène, en particulier du molybdène, ou est essentiellement formée de molybdène et/ou de tungstène, en particulier de molybdène, **en ce que** la couche barrière conductrice comprend du TiN ou est essentiellement formée de TiN, et
**en ce que** la couche de contact (8a, 8b), en particulier comprenant un/des dopant(s), comprend du, ou est essentiellement formée de, MoSe₂.

15. Procédé selon l'une quelconque des revendications 9 à 14, **caractérisé en ce que**
le dopant, en particulier des ions sodium, est présent dans la couche de contact (8a, 8b) à une concentration dans la plage de 10¹⁴ à 10¹⁷ atomes/cm², en particulier dans la plage de 10¹⁴ à 10¹⁶ atomes/cm².

16. Électrode arrière multicouche (1) obtenue à l'aide d'un procédé selon l'une quelconque des revendications précédentes, en particulier selon l'une des revendications 3-5, 8-9 et 12-15, l'électrode arrière multicouche (1) comprenant, dans cet ordre,
au moins une couche d'électrode arrière en volume (4),
au moins une couche de contact (8a, 8b), en particulier ohmique,
**caractérisée en ce que**,
la couche de contact (8a, 8b) est obtenue par :
- application d'au moins une couche contenant, ou essentiellement se composant de, au moins un chalcogénure métallique au moyen d'un dépôt physique ou chimique en phase vapeur avec utilisation d'au moins une source de chalcogénure métallique, le métal du chalcogénure métallique étant sélectionné parmi le groupe se composant de molybdène, tungstène, tantale, cobalt, zirconium et/ou niobium, le chalcogène du chalcogénure métallique étant en particulier sélectionné parmi du sélénium et/ou du soufre,
ou
- application d'au moins une couche métallique comme première couche (10), la première couche (10) et la couche d'électrode arrière en volume (4) ne correspondant relativement au métal utilisé respectivement ou, pour autant que plusieurs métaux sont présents dans la couche métallique et la couche d'électrode arrière en volume (4), relativement à au moins un, en particulier à tous ces métaux, comprenant ou se composant essentiellement de Mo, W, Ta, Nb, Zr et/ou Co au moyen de dépôt physique en phase vapeur avec utilisation d'au moins une source métallique et traitement de cette couche métallique à des températures supérieures à 300°C dans une atmosphère de chalcogéne et/ou une atmosphère de chalcogénure d'hydrogène, en particulier une atmosphère de sélénium et/ou de soufre et/ou une atmosphère H₂S et/ou H₂Se, avec formation d'une couche de chalcogénure métallique comme deuxième couche (12).

17. Électrode arrière multicouche (1) selon la revendication 16, l'épaisseur moyenne de la couche de contact (8a, 8b) se trouvant dans la plage de 100 nm à 200 nm.

18. Cellule photovoltaïque en couches minces, comprenant au moins une électrode arrière multicouche selon l'une des revendications 1 à 15.

19. Cellule photovoltaïque en couches minces selon la revendication 18, comprenant, dans cet ordre, au moins une couche de substrat (2), au moins une électrode arrière multicouche obtenue à l'aide du procédé selon l'une des revendications 1 à 15, au moins une couche de contact (8a, 8b), en particulier ohmique, au moins une couche absorbante semi-conductrice (14), en particulier directement adjacente à la couche de contact (8a, 8b), en particulier une couche absorbante semi-conductrice de chalcopyrite ou de kësterite, et au moins une électrode frontale.

20. Cellule photovoltaïque en couches minces selon la revendication 18 ou 19, **caractérisée en ce qu'**
au moins une couche tampon, en particulier au moins une couche, comprenant du, ou formée essentiellement de, CdS ou d'une couche dépourvue de CdS, en particulier contenant du, ou formée essentiellement de, Zn(S,OH) ou In₂S₃, et/ou au moins une couche, comprenant du, ou essentiellement formée de, oxyde de zinc intrinsèque et/ou oxyde de zinc avec résistance élevée, se trouve entre la couche absorbante semi-conductrice (14) et l'électrode frontale,

21. Cellule photovoltaïque en couches minces selon l'une des revendications 18 à 20. **caractérisée en ce qu'**
au moins une couche barrière conductrice, en particulier une couche barrière bidirectionnelle, se trouve entre la couche d'électrode arrière (8b) et la couche de contact (8a, 8b).

22. Cellule photovoltaïque en couches minces selon l'une des revendications 18 à 21, **caractérisée en ce que**
la couche d'absorption semi-conductrice (14) représente ou comprend une couche de chalcopyrite IB-IIIA-VIA quaternaire, en particulier une couche de Cu(In,Ga)Se₂, une couche de chalcopyrite IB-IIIA-VIA quinternaire, en particulier une couche de Cu(In,Ga(Seₓ,S₁₋ₓ)₂, ou une couche de kësterite, en particulier une couche de Cu₂ZnSn(Seₓ,S₁₋ₓ)₄-, par exemple une couche de Cu₂ZnSn(Se)₄- ou une couche de Cu₂ZnSn(S)₄-, x prenant des valeurs de 0 à 1.

23. Cellule photovoltaïque en couches minces selon l'une des revendications 18 à 22, **caractérisée en ce que**
la couche de contact (8a, 8b) comprend au moins une couche métallique et au moins une couche de chalcogénure métallique, la première de ces couches étant voisine de l'électrode arrière ou adjacente à celle-ci ou étant voisine de la couche barrière ou adjacente à celle-ci, et la deuxième de ces couches étant voisine de la couche absorbante semi-conductrice ou adjacente à celle-ci.

24. Module photovoltaïque en couches minces, comprenant au moins deux, en particulier une pluralité de, cellules photovoltaïques en couches minces monolithiques intégrées en série selon l'une des revendications 18 à 23.

25. Utilisation de la cellule photovoltaïque en couches minces selon l'une des revendications 18 à 23 pour la fabrication de modules photovoltaïques en couches minces.

26. Utilisation de l'électrode arrière multicouche (1) obtenue à l'aide du procédé selon l'une des revendications 1 à 15 pour la fabrication de cellules photovoltaïques en couches minces ou de modules photovoltaïques en couches minces.

27. Utilisation de l'électrode arrière multicouche (1) obtenue à l'aide du procédé selon l'une des revendications 9 à 15 pour le dopage d'une couche absorbante semi-conductrice (14) pendant la fabrication d'une cellule photovoltaïque en couches minces, en particulier selon l'une des revendications 18 à 23, ou d'un module photovoltaïque en couches minces, en particulier selon la revendication 24.

28. Procédé selon l'une des revendications 1 à 15 pour la fabrication d'une électrode arrière multicouche, comprenant les étapes suivantes :
application de la couche d'électrode arrière en volume (4), de la couche barrière selon la revendication 3, de la couche de contact (8a, 8b), des métaux de la couche absorbante semi-conductrice (14) selon la revendication 9 et/ou de dopants, au moyen d'un procédé physique de dépôt de couches minces, en particulier au moyen d'un revêtement par dépôt physique en phase vapeur (PVD), évaporation par système d'évaporation par faisceau d'électrons, évaporation par système d'évaporation par résistance, évaporation par induction, évaporation par arc et/ou pulvérisation cathodique (sputtering), en particulier la pulvérisation magnétron DC ou RF, respectivement de préférence sous vide poussé, ou au moyen d'un dépôt chimique en phase vapeur, en particulier comprenant le dépôt chimique en phase vapeur (CVD), le CVD à basse pression (low pressure) et/ou le CVD à pression atmosphérique (atmospheric pressure).

29. Procédé selon la revendication 28, **caractérisé en ce que**
la couche d'électrode arrière en volume (4), la couche barrière, la couche de contact (8a, 8b), les métaux de la couche absorbante semi-conductrice (14) et/ou le dopant/les dopants sont appliqués à l'aide de pulvérisation cathodique (sputtering), en particulier par pulvérisation magnétron DC.

30. Procédé selon la revendication 28 ou 29, **caractérisé en ce qu'**
le dopant/les dopants, en particulier sélectionnées) pain-ni le groupe se composant d'un composé de sodium, d'ions sodium, d'un bronze de sodium-molybdène et/ou d'un bronze de sodium-tungstène, sont appliqués conjointement avec au moins un composant de la couche de contact (8a, 8b) et/ou de la couche absorbante, en particulier d'une cible mixte ou frittée.
